# EUROPÄISCHE PATENTSCHRIFT

(11) **EP 4 056 002 B1**
(45) Veröffentlichungstag und Bekanntmachung des Hinweises auf die Patenterteilung: **19.03.2025**
(21) Anmeldenummer: 20796694.6
(22) Anmeldetag: 19.10.2020
(51) Int. Cl.: H05K 7/14, H01R 12/52, H05K 3/36, H05K 1/14

(54) **ELEKTROGERÄT, INSBESONDERE WECHSELRICHTER ODER UMRICHTER**
ELECTRICAL DEVICE, IN PARTICULAR INVERTER OR CONVERTER
DISPOSITIF ÉLECTRIQUE, EN PARTICULIER ONDULEUR OU CONVERTISSEUR

(30) Priorität: 04.11.2019 DE 102019007614
(43) Veröffentlichungstag der Anmeldung: 14.09.2022
(73) Patentinhaber: SEW-EURODRIVE GmbH & Co. KG, 76646 Bruchsal (DE)
(72) Erfinder: GROß, Werner, 76689 Karlsdorf-Neuthard (DE); SCHÖRNER, Martin, 76646 Bruchsal (DE); WETZEL, Thomas, 76698 Ubstadt-Weiher (DE); JANZER, Rolf, 76646 Bruchsal (DE)
(86) Internationale Anmeldenummer: PCT/EP2020/025463
(87) Internationale Veröffentlichungsnummer: WO 2021/089181

(56) Entgegenhaltungen:
- DE-A1- 102015 202 197
- US-A1- 2014 098 498

## Beschreibung

Die Erfindung betrifft ein Elektrogerät, insbesondere Wechselrichter oder Umrichter.

Es ist allgemein bekannt, dass elektrische Steckverbinder Kontaktstifte aufweisen, die in entsprechende Anschlusseinrichtungen beim Steckverbinden einzuführen sind.

**Aus der** US 2014/098498 A1 **ist als nächstliegender Stand der Technik ein Elektrogerät bekannt.**

**Aus der** DE 10 2015 202197 A1 **ist ein Frequenzumrichter bekannt.**

Der Erfindung liegt daher die Aufgabe zugrunde, ein sicheres Verbinden zu gewährleisten.

Erfindungsgemäß wird die Aufgabe bei dem Elektrogerät nach den in Anspruch 1 angegebenen Merkmalen gelöst.

Wichtige Merkmale der Erfindung bei dem Elektrogerät, insbesondere Wechselrichter oder Umrichter, sind, dass das Elektrogerät eine erste und eine zweite Leiterplatte aufweist,
wobei die erste Leiterplatte hervorragende Laschenbereiche aufweist,
wobei ein jeweiliger Laschenbereich in eine jeweilige Ausnehmung der zweiten Leiterplatte hineinragt,
wobei Kontaktstifte, insbesondere eines oder mehrerer Steckverbinderteil, in Löcher der zweiten Leiterplatte hineinragen.

Von Vorteil ist dabei, dass die Laschenbereiche als Führung wirksam sind, wenn die Kontaktstifte in die Löcher eingeführt werden. Außerdem ist ein mechanischer Schutz für die Kontaktstifte mittels der Laschenbereiche bewirkbar, weil diese weiter an der ersten Leiterplatte herausragen als die Kontaktstifte und somit diese beim Aufsetzen auf die zweite Leiterplatte schützen. Nur wenn die Laschenbereiche in die Ausnehmungen eingesenkt werden, können die Kontaktstifte die zweite Leiterplatte erreichen. Außerdem ist ein Verpolungsschutz einfach ausführbar, indem die mindestens drei, in einer Linie angeordneten Laschenbereiche unregelmäßig voneinander beabstandet sind. Somit ist auch bei einer Verdrehung der ersten Leiterplatte um 180° kein Einsenken aller Laschenbereiche erreichbar, insbesondere auch dann nicht, wenn alle Laschenbereiche zueinander gleich ausgeformt sind, also jeder Laschenbereich in jede Ausnehmung passen würde. Denn durch die unterschiedlichen Abstände ist das Steckverbinden nur in der vorhergesehenen Weise ausführbar.

Bei einer vorteilhaften Ausgestaltung sind die erste und die zweite Leiterplatte mit einem Kühlkörper des Elektrogeräts verbunden. Von Vorteil ist dabei, dass auf der ersten Leiterplatte ein Leistungsmodul befestigbar ist, das zumindest einen steuerbaren Halbleiterschalter aufweist und im Betrieb Wärme erzeugt, und das mit dem Kühlkörper wärmeleitend verbunden ist.

Bei einer vorteilhaften Ausgestaltung sind die Löcher durchkontaktiert ausgeführt und die jeweiligen Kontaktstifte sind mit den jeweiligen Löchern lötverbunden und/oder steckverbunden mit den jeweiligen Löchern. Von Vorteil ist dabei, dass für die Realisierung der Steckverbindung nur geringer Aufwand notwendig ist, da nur Kontaktstifte an der ersten Leiterplatte vorzusehen sind und Löcher in der zweiten Leiterplatte. Dabei bewirken die Laschenbereiche mit den Ausnehmungen zusammen eine Vorausführung, also Vor-Führung, so dass kein weiterer mechanischer Schutz für die Kontaktstifte notwendig ist.

Bei einer vorteilhaften Ausgestaltung ist die erste Leiterplatte senkrecht zur zweiten Leiterplatte ausgerichtet,
insbesondere wobei die erste Leiterplatte in einer ersten Ebene, insbesondere Leiterplattenebene, und die zweite Leiterplatte, insbesondere Leiterplattenebene, in einer zweiten Ebene angeordnet ist, wobei die erste Ebene zur zweiten Ebene senkrecht ausgerichtet ist. Von Vorteil ist dabei, dass die Laschenbereiche der ersten Leiterplatte in Ausnehmungen der zweiten Leiterplatte einsteckbar sind.

Bei einer vorteilhaften Ausgestaltung ist die erste Leiterplatte mit ihren Laschenbereichen durch Herausfräsen und/oder Herausbrechen von Material aus einer im Wesentlichen rechteckförmigen Leiterplatte hergestellt. Von Vorteil ist dabei, dass die Laschenbereiche einfach herstellbar sind und einen rechteckförmigen Querschnitt aufweisen, welcher sich an gerade Randbereiche einer der Ausnehmungen anschmiegt.

Bei einer vorteilhaften Ausgestaltung ist die erste Leiterplatte mit ihren Laschenbereichen einstückig, insbesondere einteilige, ausgebildet. Von Vorteil ist dabei, dass zur Ausbildung der Vorausführung, welche durch die Laschenbereiche bewirkt ist, keine zusätzlichen Teile notwendig sind.

Bei einer vorteilhaften Ausgestaltung ist die zweite Leiterplatte mit ihren Laschenbereichen durch Herausfräsen und/oder Herausbrechen von Material aus einer im Wesentlichen rechteckförmigen Leiterplatte hergestellt. Von Vorteil ist dabei, dass eine einfache kostengünstige Herstellung ermöglicht ist.

Bei einer vorteilhaften Ausgestaltung ist die zweite Leiterplatte mit ihren Laschenbereichen einstückig, insbesondere einteilige, ausgebildet. Von Vorteil ist dabei, dass keine weiteren Teile notwendig sind sondern durch bloße Bearbeitung die Laschenbereiche ausbildbar sind.

Bei einer vorteilhaften Ausgestaltung weist der in der Leiterplattenebene der zweiten Leiterplatte liegende Querschnitt der jeweiligen Ausnehmung vier gerade Randabschnitte aufweist, die über halbkreisförmige Randabschnitte verbunden sind,
insbesondere wobei ein erster Randabschnitt parallel zu einem zweiten Randabschnitt ausgerichtet ist und wobei ein dritter Randabschnitt parallel zu einem vierten Randabschnitt ausgerichtet ist und wobei der erste Randabschnitt senkrecht zum dritten Randabschnitt ausgerichtet ist,
insbesondere wobei der erste Randabschnitt mit dem dritten Randabschnitt über einen ersten halbkreisförmigen Randabschnitt verbunden ist,
insbesondere wobei der dritte Randabschnitt mit dem zweiten Randabschnitt über einen zweiten halbkreisförmigen Randabschnitt verbunden ist,
insbesondere wobei der zweite Randabschnitt mit dem vierten Randabschnitt über einen dritten halbkreisförmigen Randabschnitt verbunden ist,
insbesondere wobei der vierte Randabschnitt mit dem ersten Randabschnitt über einen vierten halbkreisförmigen Randabschnitt verbunden ist. Von Vorteil ist dabei, dass mit einem Bohrer oder Fräser die vier geraden Randabschnitte einfach herstellbar sind und dabei die halbkreisförmigen Randabschnitte erzeugt werden. Somit ist mittels der halbkreisförmigen Randabschnitte eine verringerte Kerbwirkung erzeugt und eine Beabstandung der geraden Randabschnitte voneinander. Der Laschenbereich liegt jeweils spielfrei oder spielarm an den vier geraden Randabschnitten an, so dass eine Führung beim Einführen der Kontaktstifte bewirkt ist.

Bei einer vorteilhaften Ausgestaltung ist der jeweilige Laschenbereich rechteckförmig ausgeführt. Von Vorteil ist dabei, dass der Querschnitt des Laschenbereichs in einer Ebene, deren Normalenrichtung parallel zur Steckverbindungsrichtung ausgerichtet ist, rechteckförmig ist und somit an den vier geraden Randbereichen der jeweiligen Ausnehmung geführt ist.

Bei einer vorteilhaften Ausgestaltung bilden erste Kontaktstifte zwischen der ersten und mittleren Laschenbereich einen ersten Steckverbinder bilden und zweite Kontaktstifte zwischen dem mittleren und dem dritten Laschenbereich einen zweiten Steckverbinder. Von Vorteil ist dabei, dass die Abstände zwischen den jeweiligen Laschenbereichen ungleich ausbildbar sind, insbesondere auch bei gleich langen Steckverbinderteilen. Somit ist eine Verpolung oder verdrehte Verbindung der beiden Leiterplatten verhinderbar.

Bei einer vorteilhaften Ausgestaltung liegen die Laschenbereiche in Flucht zueinander, insbesondere also voneinander beabstandet entlang einer ersten geraden Linie angeordnet sind. Von Vorteil ist dabei, dass die Laschenbereiche einfach einsteckbar sind in die Ausnehmungen.

Bei einer vorteilhaften Ausgestaltung sind die Kontaktstifte entlang einer zweiten geraden Linie angeordnet,
wobei die zweite Linie parallel oder identisch zur ersten geraden Linie ist. Von Vorteil ist dabei, dass eine einzige Steckrichtung, insbesondere also die selbe Steckrichtung, für die Laschenbereiche und die Kontaktstifte wirksam ist.

Bei einer vorteilhaften Ausgestaltung sind die Laschenbereiche der ersten Leiterplatte in der Ebene der ersten Leiterplatte angeordnet. Von Vorteil ist dabei, dass die erste Leiterplatte samt ihrer Laschenbereiche aus einer ursprünglichen Leiterplatte herausfräsbar sind.

Bei einer vorteilhaften Ausgestaltung sind die erste Leiterplatte und die zweite Leiterplatte jeweils starr, also nicht flexibel, ausgeführt. Von Vorteil ist dabei, dass ein Steckverbinden der beiden Leiterplatten einfach ermöglicht ist. Im Gegensatz dazu wäre bei einer flexiblen Leiterplatte, also einer Folienähnlichen Ausführung der Leiterplatten, keine wesentliche Kraft vom einen Randbereich zum die Kontaktstifte aufweisenden Randbereich der ersten Leiterplatte durchleitbar und daher die Steckverbindung nicht einfach bewirkbar.

Bei einer vorteilhaften Ausgestaltung ist eine der Ausnehmungen durchkontaktiert und der in diese Ausnehmung hineinragende Laschenbereich an seiner äußeren Oberfläche einen metallisch leidenden Bereich aufweist, insbesondere eine Leiterbahn,
insbesondere wobei die durchkontaktierte Ausnehmung und/oder der metallische Bereich mit dem Bezugspotential, insbesondere elektrisch Masse, verbunden ist,
insbesondere wobei der metallisch leitende Bereich sowohl an der Oberseite als auch an der Unterseite dieses Laschenbereichs angeordnet ist. Von Vorteil ist dabei, dass eine sichere Masseverbindung erreicht wird, bevor andere elektrische Verbindungen durch die Kontaktstifte mit den insbesondere durchkontaktierten Löchern bewirkt werden.

Bei einer vorteilhaften Ausgestaltung ragen die Laschenbereich weiter an der ersten Leiterplatte hervor als die Kontaktstifte,
insbesondere so, dass mittels der in die Ausnehmungen hineinragenden Laschenbereiche eine Vorführung beim Einstecken der Kontaktstifte in die Löcher ausgebildet ist. Von Vorteil ist dabei, dass ein mechanischer Schutz für die Kontaktstifte bewirkt ist.

Bei einer vorteilhaften Ausgestaltung ragen die Laschenbereiche in Richtung der Normale der die zweite Leiterplatte aufnehmenden Ebene weiter als die Kontaktstifte an der ersten Leiterplatte hervor,
insbesondere so, dass mittels der in die Ausnehmungen hineinragenden Laschenbereiche eine Vorführung beim Einstecken der Kontaktstifte in die Löcher ausgebildet ist. Von Vorteil ist dabei, dass eine Vorausführung ermöglicht ist. Denn auf diese Weise ist ermöglicht, dass beim Steckverbinden der ersten mit der zweiten Leiterplatte zunächst die Laschenbereiche in die Ausnehmungen ragen und durch die gerade ausgeformten Randabschnitte die im Querschnitt rechteckförmigen Laschenbereiche jeweils spielarm oder spielfrei anliegen, so dass eine Führung beim weiteren Steckverbinden erreicht ist, die ein sicheres Einfädeln der Kontaktstifte in die Löcher der zweiten Leiterplatte ermöglichen.

Bei einer vorteilhaften Ausgestaltung weisen die Laschenbereiche jeweils eine Fase, insbesondere Zentrierfase, auf. Von Vorteil ist dabei, dass das Einfädeln der Laschenbereiche erleichtert wird.

Bei einer vorteilhaften Ausgestaltung ist zumindest eines der Löcher durchkontaktiert ist und mit dem elektrischen Bezugspotential, insbesondere elektrisch Masse, verbunden ist. Von Vorteil ist dabei, dass beim Steckverbinden der ersten mit der zweiten Leiterplatte zunächst eine Masseverbindung hergestellt wird und somit Überspannungsentstehung verhindert wird.

Weitere Vorteile ergeben sich aus den Unteransprüchen. Die Erfindung ist nicht auf die Merkmalskombination der Ansprüche beschränkt. Für den Fachmann ergeben sich weitere sinnvolle Kombinationsmöglichkeiten von Ansprüchen und/oder einzelnen Anspruchsmerkmalen und/oder Merkmalen der Beschreibung und/oder der Figuren, insbesondere aus der Aufgabenstellung und/oder der sich durch Vergleich mit dem Stand der Technik stellenden Aufgabe.

Die Erfindung wird nun anhand von schematischen Abbildungen näher erläutert:

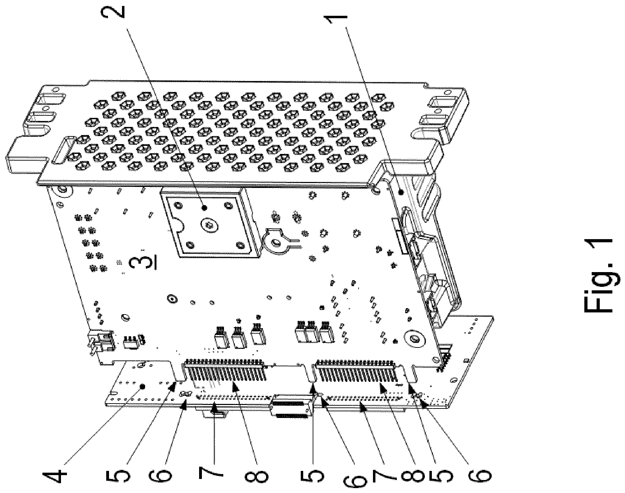

In der Figur 1 ist eine Leiterplattenanordnung eines erfindungsgemäßen Elektrogeräts in Schrägansicht dargestellt, bevor eine erste Leiterplatte 3 mit einer zweiten Leiterplatte 4 verbunden wird.

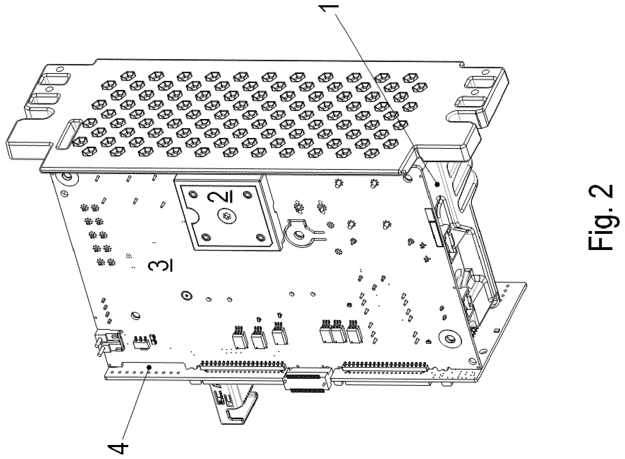

In der Figur 2 ist die Leiterplattenordnung in Schrägansicht dargestellt, nachdem die beiden Leiterplatten als Leiterplattenanordnung verbunden sind.
In der Figur 3 ist die Leiterplattenanordnung in Draufsicht dargestellt.
In der Figur 4 ist ein schematischer Schnitt durch einen Teilbereich des Verbindungsbereichs zwischen der ersten Leiterplatte 3 und der zweiten Leiterplatte 4 gezeigt.

Wie in den Figuren dargestellt, ist eine erste Leiterplatte 3 an einem Kühlkörper 1 des Elektrogeräts befestigt, insbesondere mittels Schrauben.

Außerdem ist ein Leistungsmodul 2 auf der ersten Leiterplatte 3 bestückt, welches wärmeleitend mit dem Kühlkörper 1 verbunden ist und hierzu vorzugsweise von einer in eine Gewindebohrung des Kühlkörpers eingeschraubten Schraube, insbesondere deren Schraubenkopf, angedrückt ist an den Kühlkörper 2.

Eine zweite Leiterplatte 4 weist drei oder mehr Ausnehmungen 6 auf, welche voneinander ungleichmäßig beabstandet sind und in einer geraden Linie hintereinander angeordnet sind.

Parallel dazu sind Löcher 7 auf der zweiten Leiterplatte 7 angeordnet, wobei Kontaktstifte 8 in die Löcher 7 einsteckbar sind. Diese Kontaktstifte 8 sind als Steckverbinderteil zusammengehalten, mit welchem die erste Leiterplatte 3 bestückt ist.

Um bei dem Einführen der Kontaktstifte 8 in die Löcher 7 ein Verkanten zu verhindern sind an der ersten Leiterplatte 3 hervorragende Laschenbereiche 5 ausgeformt. Diese sind durch Wegfräsen von Material der ersten Leiterplatte 3 erzeugt.

Dabei ragen die vorzugsweise schmaler als die Steckverbinderteile ausgeführten Laschenbereiche 5 weiter an der ersten Leiterplatte 3 hervor als die Kontaktstifte 8.

Dadurch kommen zuerst die das Basismaterial der ersten Leiterplatte 3 aufweisenden Laschenbereiche 5 in Kontakt mit der zweiten Leiterplatte 4 in Berührung und werden in die Ausnehmungen 6 eingeführt. Erst danach dringen die Kontaktstifte 8 in die Löcher 7 ein. Bei diesem Eindringen der Kontaktstifte 8 wird aber schon eine Führung wirksam, welche mittels der in den Ausnehmungen 6 schon befindlichen Laschenbereiche 5 wirksam ist.

Denn die Ausnehmungen 6 weisen jeweils zumindest teilweise eine Berandung auf, welche flächenhaft oder zumindest linienhaft am Laschenbereich 5 anliegt.

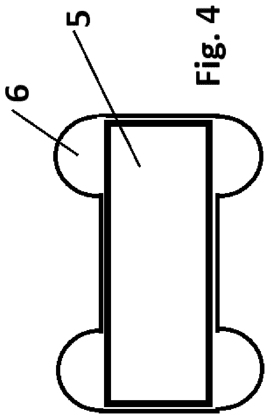

Wie in Figur 4 gezeigt weist der jeweilige Laschenbereich 5 einen rechteckförmigen Querschnitt auf. Der Querschnitt der Ausnehmung 6 hingegen weist zwar auch vier gerade Randabschnitte auf, jedoch sind diese verbunden über halbkreisförmige Randabschnitte.

Die Laschenbereiche 5 sind also jeweils im Wesentlichen quaderförmig ausgeformt. Die Ausnehmungen 6 sind mit einem Werkzeug, wie Bohrer oder Fräser, erzeugbar, dessen Drehachse parallel zur Normalen der Leiterplattenebene der zweiten Leiterplatte 4 ausgerichtet ist. Denn der Fräser muss nur entlang einer geraden Linie bewegt werden, um die in Figur 4 obere horizontale Linie zu erzeugen, und dann senkrecht dazu, um die in Figur 4 linke vertikale Linie zu erzeugen, wobei dabei die beiden Halbkreise der linken Bildhälfte entstehen. Danach kann das Werkzeug wieder vertikal verfahren werden, um die in Figur 4 untere horizontale Linie zu erzeugen, und dann wieder senkrecht dazu, um die in Figur 4 vertikale Linie zu erzeugen.

An den vier geraden Randbereichen liegt der Laschenbereich 5 schon an, während die Kontaktstifte 8 eingefädelt werden. Somit ist dieses Einfädeln von den Laschenbereichen 5 geführt und ein Verkanten des Steckverbinderteils verhindert.

Durch die unregelmäßige Beabstandung der Laschenbereiche 5 voneinander ist eine verdrehte Montage der Leiterplatten 3 und 4 verhinderbar.

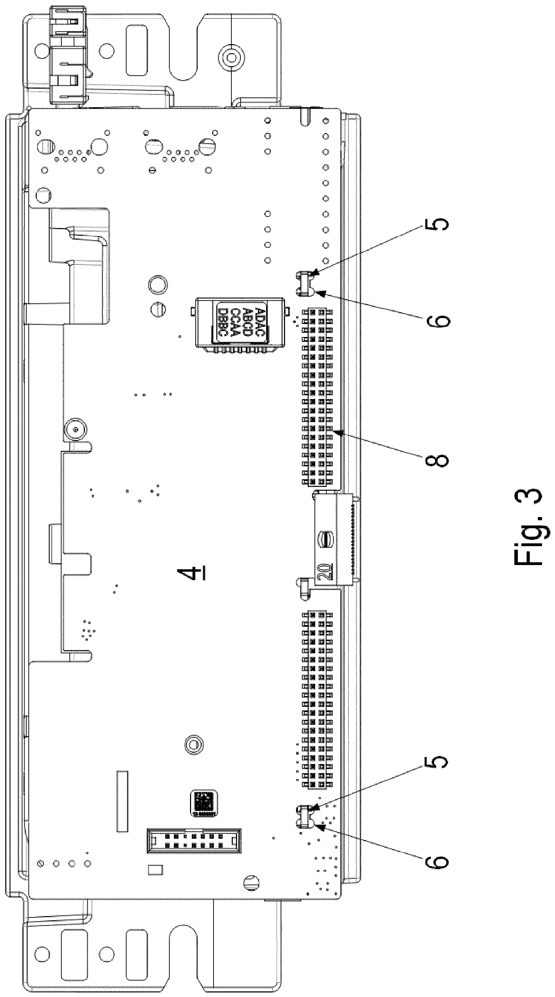

Wie in Figur 3 erkennbar, ist der Abstand vom ersten Laschenbereich 5 zum mittleren Laschenbereich kleiner als der Abstand vom letzten Laschenbereich 5 zum mittleren Laschenbereich 5. Somit ist ein Verbinden der beiden Leiterplatten (3, 4) bei um 180° gedrehter erster Leiterplatte 3 nicht ausführbar, da die drei Laschenbereiche 5 nicht in die Ausnehmungen einführbar sind.

Die hervorstehenden Laschenbereiche 5 erzeugen aber auch eine Schutzwirkung für die Kontaktstifte 8 beim Transport oder dergleichen.

Zwischen dem ersten Laschenbereich 5 und dem mittleren Laschenbereich 5 sind die Kontaktstifte 8 des ersten Steckverbinderteils angeordnet.

Zwischen dem dritten Laschenbereich 5 und dem mittleren Laschenbereich 5 sind die Kontaktstifte 8 des zweiten Steckverbinderteils angeordnet.

Indem eine der Ausnehmungen und/oder eines der Löcher durchkontaktiert ausgeführt sind, ist beim Steckverbinden der beiden Leiterplatten 3 und 4 erreichbar, dass zunächst das Bezugspotential übergeben wird und erst danach die anderen elektrischen Verbindungen geschlossen werden, insbesondere zwischen den Kontaktstiften und weiteren Durchkontaktierungen der Löcher.

Die Leiterplatten 3 und 4 werden starr ausgeführt, also nicht als flexible biegbare Leiterplatten. Das Basismaterial der Leiterplatten 3 und 4 weist vorzugsweise ein Epoxidharz auf. Die Leiterplatten 3 und 4 werden hier als plattenförmig, also quasi-zweidimensionale Teile, betrachtet. Somit ist jede der Leiterplatten 3 und 4 in einer jeweiligen Leiterplattenebene angeordnet. Die Richtungen der beiden Normalen der Leiterplattenebenen sind senkrecht zueinander ausgerichtet.

Bei weiteren erfindungsgemäßen Ausführungsbeispielen wird der Laschenbereich mit einer Leiterbahn ausgebildet, die mit dem Bezugspotential, insbesondere elektrisch Masse, verbunden ist. Zusätzlich ist dann die Ausnehmung 6 durchkontaktiert, so dass beim Berühren der Ausnehmung 6 durch den Laschenbereich 5 eine Erdung ausgeführt ist. Alternativ oder zusätzlich ist aber auch zumindest eines der Löcher durchkontaktierbar, welches mit dem Bezugspotential, insbesondere elektrisch Masse, verbunden ist. Somit ist gesichert, dass die Verbindung mit Bezugspotential direkt beim Einfädeln der Kontaktstifte 8 ausführbar ist.

### Bezugszeichenliste

1 Kühlkörper
2 Leistungsmodul
3 erste Leiterplatte
4 zweite Leiterplatte
5 Laschenbereich
6 Ausnehmung
7 Loch
8 Kontaktstift

## Patentansprüche

1. Elektrogerät, insbesondere Wechselrichter oder Umrichter,
wobei das Elektrogerät eine erste und eine zweite Leiterplatte (3, 4) aufweist,
**wobei** die erste Leiterplatte (3) hervorragende Laschenbereiche (5) aufweist,
wobei ein jeweiliger Laschenbereich (5) in eine jeweilige Ausnehmung (6) der zweiten Leiterplatte (4) hineinragt,
wobei **in die erste Leiterplatte (3) bestückte** Kontaktstifte (8), insbesondere eines oder mehrerer Steckverbinderteile, in Löcher der zweiten Leiterplatte (4) hineinragen,
**dadurch gekennzeichnet, dass**
**der in der Leiterplattenebene der zweiten Leiterplatte (4) liegende Querschnitt der jeweiligen Ausnehmung (6) vier gerade Randabschnitte aufweist, die über halbkreisförmige Randabschnitte verbunden sind.**

2. Elektrogerät nach Anspruch 1,
**dadurch gekennzeichnet, dass**
die erste und die zweite Leiterplatte (3, 4) mit einem Kühlkörper (1) des Elektrogeräts verbunden sind.

3. Elektrogerät nach einem der vorangegangenen Ansprüche,
**dadurch gekennzeichnet, dass**
die Löcher durchkontaktiert ausgeführt sind und die jeweiligen Kontaktstifte (8) mit den jeweiligen Löchern lötverbunden und/oder steckverbunden sind mit den jeweiligen Löchern.

4. Elektrogerät nach einem der vorangegangenen Ansprüche,
**dadurch gekennzeichnet, dass**
die erste Leiterplatte (3) senkrecht zur zweiten Leiterplatte (4) ausgerichtet ist,
insbesondere wobei die erste Leiterplatte (3) in einer ersten Ebene, insbesondere Leiterplattenebene, und die zweite Leiterplatte (4), insbesondere Leiterplattenebene, in einer zweiten Ebene angeordnet ist, wobei die erste Ebene zur zweiten Ebene senkrecht ausgerichtet ist.

5. Elektrogerät nach einem der vorangegangenen Ansprüche,
**dadurch gekennzeichnet, dass**
die erste Leiterplatte (3) mit ihren Laschenbereichen (5) durch Herausfräsen und/oder Herausbrechen von Material aus einer im Wesentlichen rechteckförmigen Leiterplatte hergestellt ist
und/oder dass
die erste Leiterplatte (3) mit ihren Laschenbereichen (5) einstückig, insbesondere einteilige, ausgebildet ist.

6. Elektrogerät nach einem der vorangegangenen Ansprüche,
**dadurch gekennzeichnet, dass**
die zweite Leiterplatte (4) mit ihren Laschenbereichen (5) durch Herausfräsen und/oder Herausbrechen von Material aus einer im Wesentlichen rechteckförmigen Leiterplatte hergestellt ist
und/oder dass
die zweite Leiterplatte (4) mit ihren Laschenbereichen (5) einstückig, insbesondere einteilige, ausgebildet ist.

7. Elektrogerät nach einem der vorangegangenen Ansprüche,
**dadurch gekennzeichnet, dass**
ein erster Randabschnitt parallel zu einem zweiten Randabschnitt ausgerichtet ist und wobei ein dritter Randabschnitt parallel zu einem vierten Randabschnitt ausgerichtet ist und wobei der erste Randabschnitt senkrecht zum dritten Randabschnitt ausgerichtet ist,
insbesondere wobei der erste Randabschnitt mit dem dritten Randabschnitt über einen ersten halbkreisförmigen Randabschnitt verbunden ist,
insbesondere wobei der dritte Randabschnitt mit dem zweiten Randabschnitt über einen zweiten halbkreisförmigen Randabschnitt verbunden ist,
insbesondere wobei der zweite Randabschnitt mit dem vierten Randabschnitt über einen dritten halbkreisförmigen Randabschnitt verbunden ist,
insbesondere wobei der vierte Randabschnitt mit dem ersten Randabschnitt über einen vierten halbkreisförmigen Randabschnitt verbunden ist.

8. Elektrogerät nach einem der vorangegangenen Ansprüche,
**dadurch gekennzeichnet, dass**
der jeweilige Laschenbereich rechteckförmig ausgeführt ist.

9. Elektrogerät nach einem der vorangegangenen Ansprüche,
**dadurch gekennzeichnet, dass**
erste Kontaktstifte (8) zwischen der ersten und mittleren Laschenbereich einen ersten Steckverbinder bilden und zweite Kontaktstifte (8) zwischen dem mittleren und dem dritten Laschenbereich (5) einen zweiten Steckverbinder bilden.

10. Elektrogerät nach einem der vorangegangenen Ansprüche,
**dadurch gekennzeichnet, dass**
die Laschenbereiche (5) in Flucht zueinander liegen, insbesondere also voneinander beabstandet entlang einer ersten geraden Linie angeordnet sind.

11. Elektrogerät nach einem der vorangegangenen Ansprüche,
**dadurch gekennzeichnet, dass**
die Kontaktstifte (8) entlang einer zweiten geraden Linie angeordnet sind,
wobei die zweite Linie parallel oder identisch zur ersten geraden Linie ist.

12. Elektrogerät nach einem der vorangegangenen Ansprüche,
**dadurch gekennzeichnet, dass**
die Laschenbereiche (5) der ersten Leiterplatte (3) in der Ebene der ersten Leiterplatte (3) angeordnet sind
und/oder dass
die erste Leiterplatte (3) und die zweite Leiterplatte (4) jeweils starr, also nicht flexibel, ausgeführt sind.

13. Elektrogerät nach einem der vorangegangenen Ansprüche,
**dadurch gekennzeichnet, dass**
eine der Ausnehmungen durchkontaktiert ist und der in diese Ausnehmung (6) hineinragende Laschenbereich (5) an seiner äußeren Oberfläche einen metallisch leidenden Bereich aufweist, insbesondere eine Leiterbahn,
insbesondere wobei die durchkontaktierte Ausnehmung (6) und/oder der metallische Bereich mit dem Bezugspotential, insbesondere elektrisch Masse, verbunden ist,
insbesondere wobei der metallisch leitende Bereich sowohl an der Oberseite als auch an der Unterseite dieses Laschenbereichs angeordnet ist.

14. Elektrogerät nach einem der vorangegangenen Ansprüche, **dadurch gekennzeichnet, dass**
die Laschenbereiche (5) weiter an der ersten Leiterplatte (3) hervorragen als die Kontaktstifte (8),
insbesondere so, dass mittels der in die Ausnehmungen hineinragenden Laschenbereiche (5) eine Vorführung beim Einstecken der Kontaktstifte (8) in die Löcher ausgebildet ist,
und/oder dass,
die Laschenbereiche (5) in Richtung der Normale der die zweite Leiterplatte (4) aufnehmenden Ebene weiter als die Kontaktstifte (8) an der ersten Leiterplatte (3) hervorragen,
insbesondere so, dass mittels der in die Ausnehmungen hineinragenden Laschenbereiche (5) eine Vorführung beim Einstecken der Kontaktstifte (8) in die Löcher ausgebildet ist.

15. Elektrogerät nach einem der vorangegangenen Ansprüche,
**dadurch gekennzeichnet, dass**
die Laschenbereiche (5) jeweils eine Fase, insbesondere Zentrierfase, aufweisen und/oder dass
zumindest eines der Löcher durchkontaktiert ist und mit dem elektrischen Bezugspotential, insbesondere elektrisch Masse, verbunden ist.

## Claims

1. Electrical device, in particular an inverter or a converter,
wherein the electrical device comprises a first and a second printed circuit board (3, 4),
wherein the first printed circuit board (3) comprises protruding tab regions (5),
wherein a respective tab region (5) protrudes into a respective cutout (6) in the second printed circuit board (4),
wherein contact pins (8), in particular one or more plug-in connector parts, mounted in the first printed circuit board (3) protrude into holes in the second printed circuit board (4), **characterized in that**
the cross-section of the respective cutout (6), which cross-section is located in the printed circuit board plane of the second printed circuit board (4), has four straight edge portions which are connected via semicircular edge portions.

2. Electrical device according to claim 1,
**characterized in that**
the first and the second printed circuit board (3, 4) are connected to a heat sink (1) of the electrical device.

3. Electrical device according to any one of the preceding claims,
**characterized in that**
the holes are plated through and the respective contact pins (8) are connected to the respective holes by way of soldering and/or are connected to the respective holes by way of a plug-in connection.

4. Electrical device according to any one of the preceding claims,
**characterized in that**
the first printed circuit board (3) is oriented perpendicular to the second printed circuit board (4),
in particular wherein the first printed circuit board (3) is arranged in a first plane, in particular printed circuit board plane, and the second printed circuit board (4) is arranged in a second plane, in particular printed circuit board plane, the first plane being oriented perpendicular to the second plane.

5. Electrical device according to any one of the preceding claims,
**characterized in that**
the first printed circuit board (3) is produced with its tab regions (5) by milling out and/or breaking out material from a substantially rectangular printed circuit board,
and/or **in that**
the first printed circuit board (3) is formed integrally, in particular in one piece, with its tab regions (5).

6. Electrical device according to any one of the preceding claims,
**characterized in that**
the second printed circuit board (4) is produced with its tab regions (5) by milling out and/or breaking out material from a substantially rectangular printed circuit board,
and/or **in that**
the second printed circuit board (4) is formed integrally, in particular in one piece, with its tab regions (5).

7. Electrical device according to any one of the preceding claims,
**characterized in that**
a first edge portion is oriented parallel to a second edge portion, and wherein a third edge portion is oriented parallel to a fourth edge portion, and wherein the first edge portion is oriented perpendicular to the third edge portion,
in particular wherein the first edge portion is connected to the third edge portion via a first semicircular edge portion,
in particular wherein the third edge portion is connected to the second edge portion via a second semicircular edge portion,
in particular wherein the second edge portion is connected to the fourth edge portion via a third semicircular edge portion, in particular wherein the fourth edge portion is connected to the first edge portion via a fourth semicircular edge portion.

8. Electrical device according to any one of the preceding claims,
**characterized in that**
the respective tab region is rectangular.

9. Electrical device according to any one of the preceding claims,
**characterized in that**
first contact pins (8) between the first and the middle tab region form a first plug-in connector, and second contact pins (8) between the middle and the third tab region (5) form a second plug-in connector.

10. Electrical device according to any one of the preceding claims,
**characterized in that**
the tab regions (5) are in alignment with one another, i.e. in particular are arranged at a distance from one another along a first straight line.

11. Electrical device according to any one of the preceding claims,
**characterized in that**
the contact pins (8) are arranged along a second straight line, wherein the second line is parallel to and/or identical to the first straight line.

12. Electrical device according to any one of the preceding claims,
**characterized in that**
the tab regions (5) of the first printed circuit board (3) are arranged in the plane of the first printed circuit board (3), and/or **in that**
the first printed circuit board (3) and the second printed circuit board (4) are each rigid, i.e. inflexible.

13. Electrical device according to any one of the preceding claims,
**characterized in that**
one of the cutouts is plated through and the tab region (5) protruding into this cutout (6) has a metallically conductive region, in particular a conductor track, on its outer surface, in particular wherein the plated-through cutout (6) and/or the metallic region is connected to the reference potential, in particular to electrical ground,
in particular wherein the metallically conductive region is arranged both on the top side and on the bottom side of this tab region.

14. Electrical device according to any one of the preceding claims,
**characterized in that**
the tab regions (5) protrude further on the first printed circuit board (3) than the contact pins (8),
in particular such that a pre-guide during the insertion of the contact pins (8) into the holes is formed by means of the tab regions (5) protruding into the cutouts,
and/or **in that**
the tab regions (5) protrude further in the direction of the normal of the plane containing the second printed circuit board (4) than the contact pins (8) on the first printed circuit board (3),
in particular such that a pre-guide during the insertion of the contact pins (8) into the holes is formed by means of the tab regions (5) protruding into the cutouts.

15. Electrical device according to any one of the preceding claims,
**characterized in that**
the tab regions (5) each have a chamfer, in particular a centering chamfer,
and/or **in that**
at least one of the holes is plated through and is connected to the electrical reference potential, in particular to electrical ground.

## Revendications

1. Appareil électrique, en particulier onduleur ou convertisseur,
l'appareil électrique présentant une première et une seconde carte de circuit imprimé (3, 4),
la première carte de circuit imprimé (3) présentant des régions de languette en saillie (5),
une région de languette respective (5) faisant saillie dans un évidement respectif (6) de la seconde carte de circuit imprimé (4),
des broches de contact (8) équipant la première carte de circuit imprimé (3), en particulier d'une ou de plusieurs parties de connecteur enfichable, faisant saillie dans des trous de la seconde carte de circuit imprimé (4),
**caractérisé en ce que**
la section transversale de l'évidement respectif (6) située dans le plan de carte de circuit imprimé de la seconde carte de circuit imprimé (4) présente quatre sections de bord droites qui sont connectées par des sections de bord semi-circulaire.

2. Appareil électrique selon la revendication 1,
**caractérisé en ce que**
la première et la seconde carte de circuit imprimé (3, 4) sont connectées à un dissipateur thermique (1) de l'appareil électrique.

3. Appareil électrique selon l'une quelconque des revendications précédentes, **caractérisé en ce que**
les trous sont réalisés métallisés et les broches de contact respectives (8) sont soudées aux trous respectifs et/ou connectées aux trous respectifs.

4. Appareil électrique selon l'une quelconque des revendications précédentes, **caractérisé en ce que**
la première carte de circuit imprimé (3) est orientée perpendiculairement à la seconde carte de circuit imprimé (4),
la première carte de circuit imprimé (3) étant en particulier agencée dans un premier plan, en particulier un plan de carte de circuit imprimé, et la seconde carte de circuit imprimé (4) étant agencée dans un second plan, en particulier un plan de carte de circuit imprimé, le premier plan étant orienté perpendiculairement par rapport au second plan.

5. Appareil électrique selon l'une quelconque des revendications précédentes, **caractérisé en ce que**
la première carte de circuit imprimé (3) est fabriquée avec ses régions de languette (5) par fraisage et/ou rupture de matériau à partir d'une carte de circuit imprimé sensiblement rectangulaire
et/ou **en ce que**
la première carte de circuit imprimé (3) est réalisée d'un seul tenant, en particulier d'une seule pièce, avec ses régions de languette (5).

6. Appareil électrique selon l'une quelconque des revendications précédentes, **caractérisé en ce que**
la seconde carte de circuit imprimé (4) avec ses régions de languette (5) est fabriquée par fraisage et/ou rupture de matériau à partir d'une carte de circuit imprimé sensiblement rectangulaire
et/ou **en ce que**
la seconde carte de circuit imprimé (4) est réalisée d'un seul tenant, en particulier d'une seule pièce, avec ses régions de languette (5).

7. Appareil électrique selon l'une quelconque des revendications précédentes, **caractérisé en ce que**
une première partie de bord est orientée parallèlement à une deuxième partie de bord et une troisième partie de bord est orientée parallèlement à une quatrième partie de bord, et la première partie de bord est orientée perpendiculairement à la troisième partie de bord,
la première partie de bord étant en particulier connectée à la troisième partie de bord par une première partie de bord semi-circulaire,
la troisième partie de bord étant en particulier connectée à la deuxième partie de bord par une deuxième partie de bord semi-circulaire,
la deuxième partie de bord étant en particulier connectée à la quatrième partie de bord par une troisième partie de bord semi-circulaire,
la quatrième partie de bord étant en particulier connectée à la première partie de bord par une quatrième partie de bord semi-circulaire.

8. Appareil électrique selon l'une quelconque des revendications précédentes, **caractérisé en ce que**
la région de languette respective est réalisée en forme de rectangle.

9. Appareil électrique selon l'une quelconque des revendications précédentes, **caractérisé en ce que**
les premières broches de contact (8) entre la première et la région de languette centrale forment un premier connecteur enfichable et les secondes broches de contact (8) entre la région de languette centrale et la troisième région de languette (5) forment un second connecteur enfichable.

10. Appareil électrique selon l'une quelconque des revendications précédentes, **caractérisé en ce que**
les régions de languette (5) sont agencées alignées les unes par rapport aux autres, en particulier également espacées les unes des autres le long d'une première ligne droite.

11. Appareil électrique selon l'une quelconque des revendications précédentes, **caractérisé en ce que**
les broches de contact (8) sont agencées le long d'une seconde ligne droite,
la seconde ligne étant parallèle ou identique à la première ligne droite.

12. Appareil électrique selon l'une quelconque des revendications précédentes, **caractérisé en ce que**
les régions de languette (5) de la première carte de circuit imprimé (3) sont agencées dans le plan de la première carte de circuit imprimé (3)
et/ou **en ce que**
la première carte de circuit imprimé (3) et la seconde carte de circuit imprimé (4) sont chacune conçues de manière rigide, c'est-à-dire non flexible.

13. Appareil électrique selon l'une quelconque des revendications précédentes, **caractérisé en ce que**
l'un des évidements est métallisé et la région de languette (5) qui fait saillie dans cet évidement (6) présente sur sa surface extérieure une région métallique, en particulier une piste conductrice,
en particulier dans lequel l'évidement métallisé (6) et/ou la région métallique sont connectés au potentiel de référence, en particulier la masse électrique,
la région métallique conductrice étant en particulier agencée à la fois sur la face supérieure et sur la face inférieure de cette région de languette.

14. Appareil électrique selon l'une quelconque des revendications précédentes, **caractérisé en ce que**
les régions de languette (5) font davantage saillie au niveau de la première carte de circuit imprimé (3) que les broches de contact (8),
en particulier de manière à ce qu'une projection soit réalisée lors de l'insertion des broches de contact (8) dans les trous au moyen des régions de languette (5) faisant saillie dans les évidements,
et/ou **en ce que**,
les régions de languette (5) font davantage saillie que les broches de contact (8) au niveau de la première carte de circuit imprimé (3) en direction de la normale au plan recevant la seconde carte de circuit imprimé (4),
en particulier de manière à ce qu'une projection soit réalisée lors de l'insertion des broches de contact (8) dans les trous au moyen des régions de languette (5) faisant saillie dans les évidements.

15. Appareil électrique selon l'une quelconque des revendications précédentes, **caractérisé en ce que**
les régions de languette (5) présentent chacune un chanfrein, en particulier un chanfrein de centrage
et/ou **en ce que**
au moins un des trous est traversé et est connecté au potentiel de référence électrique, en particulier à la masse électrique.
